(19) Europäisches Patentamt
European Patent Office
Office européen des brevets

(11) EP 2 707 734 B1

(12) **EUROPÄISCHE PATENTSCHRIFT**

(45) Veröffentlichungstag und Bekanntmachung des Hinweises auf die Patenterteilung:
**25.09.2019 Patentblatt 2019/39**

(21) Anmeldenummer: **12751020.4**

(22) Anmeldetag: **02.08.2012**

(51) Int Cl.:
*G01R 31/312* *(2006.01)*     *G01B 7/06* *(2006.01)*

(86) Internationale Anmeldenummer:
**PCT/EP2012/065170**

(87) Internationale Veröffentlichungsnummer:
**WO 2013/029915 (07.03.2013 Gazette 2013/10)**

(54) **KONTAKTLOSER KAPAZITIVER ABSTANDSSENSOR**

CONTACTLESS CAPACITIVE DISTANCE SENSOR

CAPTEUR DE DISTANCE CAPACITIF SANS CONTACT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.08.2011 DE 102011081666**

(43) Veröffentlichungstag der Anmeldung:
**19.03.2014 Patentblatt 2014/12**

(73) Patentinhaber: **Siemens Aktiengesellschaft 80333 München (DE)**

(72) Erfinder:
• **ALATAS, Fatih**
**81737 München (DE)**
• **KÖRDEL, Martin**
**80797 München (DE)**
• **SCHICK, Anton**
**84149 Velden (DE)**

(56) Entgegenhaltungen:
**DE-A1-102009 022 965     US-A- 4 958 129**
**US-A1- 2002 163 342**

• **KOERDEL M ET AL: "Contactless inspection of planar electronic devices by capacitive coupling: Development of a model describing the sensor signal and its impact on signal post-processing", SENSORS AND ACTUATORS A, Bd. 172, Nr. 1, 4. März 2011 (2011-03-04), Seiten 88-97, XP028397424, ISSN: 0924-4247, DOI: 10.1016/J.SNA.2011.02.040 [gefunden am 2011-03-04]**

**Beschreibung**

Die Erfindung betrifft eine Vorrichtung und ein Verfahren zur kontaktlosen und zerstörungsfreien Inspektion von elektrisch leitenden Strukturen, die auf oder in einem Substrat oder floatend in einem Substrat erzeugt sind.

Die Erfindung betrifft insbesondere die kontaktlose und zerstörungsfreie Inspektion von elektrisch leitenden Strukturen auf sich jeweils entlang einer Fläche erstreckenden Substraten. Entsprechende Substrate kommen beispielsweise bei sogenannten Display-Backplanes oder gedruckten Schaltungen vor. Eine elektrische Überprüfung entsprechender Strukturen ist vor Fertigstellung des gesamten Displays nur bedingt möglich. Das gilt vor allem für Strukturen mit Längen im mm- oder μm-Bereich oder ohne direkten Kontakt zum Rand eines Substrats.

Floatend ist eine elektrisch leitende Struktur dann, wenn diese in einem Substrat vollständig eingeschlossen ist, keinen direkten Kontakt zu einem Rand oder Oberfläche des Substrates aufweist und elektrisch isoliert ist.

Eine Möglichkeit zur Überprüfung der elektrischen Funktionalität ist die Verwendung einer herkömmlichen Nadelprobe. Hierbei werden Nadeln an die entsprechenden leitenden Flächen in den Substraten gedrückt und elektrische Verbindungen hergestellt. Anschließend kann die Struktur zwischen den Nadelkontakten auf elektrische Leitfähigkeit beziehungsweise hinsichtlich der Funktionalität untersucht werden. Ein derartiges Verfahren weist allerdings einige Nachteile auf. Eine beschädigungsfreie Ankontaktierung ist nicht beziehungsweise lediglich bedingt möglich. Darüber hinaus ist die Ankontaktierung selbst ebenso verhältnismäßig aufwendig. So müssen die Nadeln genau justiert werden und mit einem definierten Druck die Ankontaktierung gewährleisten. Dabei erfahren die Nadeln ebenso eine mechanische Abnutzung. Auf Grund dieses aufwendigen Prozesses ist die Inspektion von vielen Flächen und somit eine "Inline"-Inspektion lediglich bedingt effizient umsetzbar.

Eine weitere herkömmliche Messmethode ist die optische Inspektion. Diese kann nichts über die elektrischen Eigenschaften beziehungsweise über die einwandfreie Funktionalität aussagen. Allerdings eignet sich diese zur Materialinspektion. Dadurch kann die laterale Geometrie von Strukturen überprüft werden. Risse in elektrisch leitenden Strukturen oder Kurzschlüsse in unteren Lagen zwischen tiefer liegenden Leiterbahnen, die zu einem Fehlverhalten führen, können allerdings nicht sicher erkannt werden.

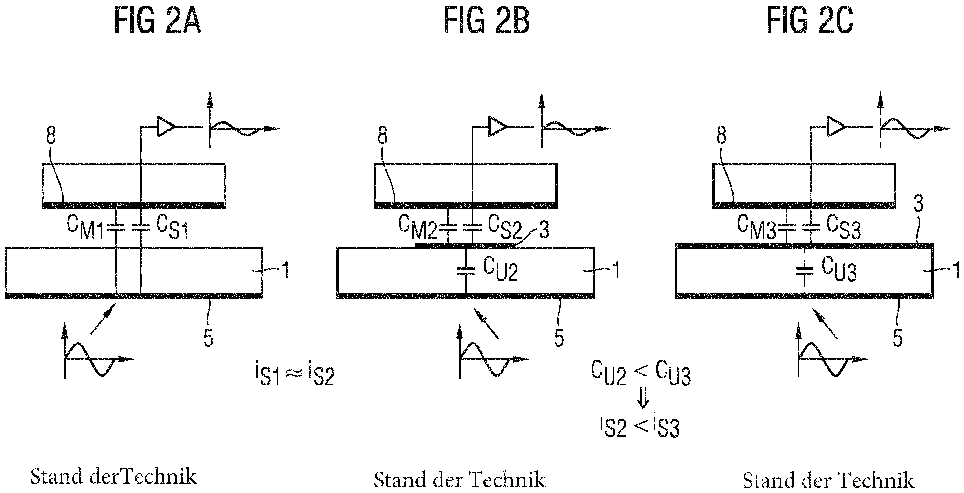

Eine weitere herkömmliche Lösung gemäß der DE 10 2008 030545 A1 ist die sogenannte berührungslose kapazitive Inspektion. Hierbei wird zwischen der Substratoberfläche und dem Sensor eine vom Ort abhängige Kapazität gebildet. An diese kapazitive Kopplung können anschließend Spannungen- und Kapazitätsänderungen detektiert werden. Dadurch ist es möglich die Oberfläche des Substrates kapazitiv abzutasten beziehungsweise angelegte Spannungen auf der Substratoberfläche zu berechnen. Die Substrate müssen für entsprechende Messungen entsprechend mit Signalen versorgt werden. Im Falle der kapazitiven Oberflächenabtastung kann die Signalzuführung zu dem Substrat ebenso kapazitiv über eine elektrisch leitende Auflagefläche angeregt werden. In Folge der kapazitiven Kopplung reagiert das Messsignal auf Änderungen der Leitfähigkeit beziehungsweise der Kapazität und ist somit für die elektrische Inspektion entsprechender Strukturen viel besser geeignet als entsprechende optische Verfahren. Dieses herkömmliche Verfahren zeigt Figur 2. Bei diesem Verfahren ist es allerdings nicht möglich sehr kleine elektrisch nicht angeschlossene, das heißt floatende, Strukturen zu inspizieren. Folglich können diese Strukturen nicht direkt mit einem Signal beaufschlagt werden. Eine kapazitive Ankopplung über die Substrataufnahme ist in diesem Fall nicht möglich. Für ein messbares Signal muss die Koppelfläche von der Substrataufnahme entscheidend größer sein als die Koppelfläche zum Sensor, ansonsten kann der Unterschied zwischen den Messergebnissen "Struktur vorhanden" und "Struktur nicht vorhanden" nicht gemessen werden.

Die DE 10 2009 022 965 A1 offenbart ein Verfahren sowie eine Vorrichtung zur Messung eines Substrats mit elektrisch leitenden Strukturen. Um eine solche Messung zu verbessern, wird vorgeschlagen, dass die Vorrichtung einen Messsensor und Mittel zur gesteuerten Bewegung des Messsensors relativ zum Substrat aufweist, wobei die Vorrichtung Mittel zur gleichzeitigen Einspeisung mehrerer unterschiedlicher elektrischer Signale in die elektrisch leitenden Strukturen aufweist.

Darüber hinaus ist aus der US 2002/0163342 A1 eine Analyseeinrichtung zur Analyse einer Verdrahtung einer Leiterplatte bekannt. Hierbei umfasst die Analyseeinrichtung ein Leitelement, mittels welchem ein Analysesignal an eine erste Oberfläche der Leiterplatte übertragen werden kann. Des Weiteren umfasst die Analyseeinrichtung eine Mehrzahl von Messzellen, welche auf einer der ersten Oberfläche gegenüberliegenden zweiten Oberfläche angeordnet sind und mittels welcher jeweilige Antwortsignale in Abhängigkeit von dem Analysesignal aufnehmbar sind. Anhand der Antwortsignale können Bilddaten mittels der Analyseeinrichtung zur Auswertung der Antwortdaten erstellt werden.

Es ist Aufgabe der Erfindung eine Vorrichtung und ein Verfahren zur kontaktlosen und zerstörungsfreien Inspektion von elektrisch leitenden Strukturen derart bereit zu stellen, dass in einem kartesischen x-, y-, z- Koordinatensystem eine Erstreckung einer elektrisch leitenden Struktur entlang der z- Achse und/oder eine Erstreckung der elektrisch leitenden Struktur entlang der x-, y- Ebene einfach und zuverlässig erfasst werden. Es soll eine Vielzahl von elektrisch leitenden Strukturen wirksam inspiziert werden können. Es sollen beispielsweise Risse in den elektrisch leitenden Strukturen oder Kurzschlüsse zwischen in einem Substrat liegenden Leiterbahnen zuverlässig erkannt werden. Es sollen elektrische Strukturen auf oder in einem Substrat und floatende elektrische Strukturen inspiziert werden können. Es sollen beispielsweise Display-Substrate und gedruckte Schaltungen inspiziert werden können.

Die Aufgabe wird durch eine Vorrichtung gemäß dem Hauptanspruch und allen Verfahren gemäß dem Nebenanspruch gelöst.

Gemäß einem ersten Aspekt wird eine Vorrichtung zur kapazitiven kontaktlosen und zerstörungsfreien Inspektion einer Vielzahl von auf oder in einem Substrat erzeugten elektrisch leitenden Strukturen bereitgestellt, mit einem das Substrat positionierenden elektrisch leitenden Substrathalter, an den ein mittels einer Anregungssignalerzeugungseinrichtung erzeugtes Anregungssignal angelegt ist; einem auf der dem Substrathalter abgewandten Seite des Substrats positionierten, mindestens zwei mit zueinander unterschiedlichen, konstanten Abständen zu einer Oberfläche des Substrats parallel und relativ zu dieser nebeneinander angeordneten Sensorelektrodenflächen aufweisenden kapazitiven Sensor; einer Messeinrichtung zur Erfassung eines jeweiligen Sensormesssignals an einer jeweiligen Sensorelektrodenfläche; einer Auswerteeinrichtung zur Bestimmung einer räumlichen Erstreckung einer elektrisch leitenden Struktur mittels der erfassten Sensormesssignale.

Gemäß einem zweiten Aspekt wird ein Verfahren zur kapazitiven kontaktlosen und zerstörungsfreien Inspektion einer Vielzahl von auf oder in einem Substrat erzeugten elektrisch leitenden Strukturen, mit den Schritten bereitgestellt. Positionieren des Substrats mittels eines elektrisch leitenden Substrathalters, an den ein mittels einer Anregungssignalerzeugungseinrichtung erzeugtes Anregungssignal angelegt wird; Positionieren eines mindestens zwei mit zueinander unterschiedlichen, konstanten Abständen parallel zu einer Oberfläche des Substrats und relativ zu dieser nebeneinander angeordneten Sensorelektrodenflächen aufweisenden kapazitiven Sensor auf der dem Substrathalter abgewandten Seite des Substrats; Erfassen eines jeweiligen Sensormesssignals an einer jeweiligen Sensorelektrodenfläche mittels einer Messeinrichtung; mittels einer Auswerteeinrichtung ausgeführtes Bestimmen einer räumlichen Erstreckung einer elektrisch leitenden Struktur mittels der erfassten Sensormesssignale.

Gemäß der vorliegenden Erfindung wird ein dreidimensional gestalteter kapazitiver Sensor mit Sensorelektroden verwendet. Dabei werden mindestens zwei benachbarte Sensorelektroden verwendet, wobei diese gegeneinander vertikal einen Versatz aufweisen. Die erfindungsgemäße Vorrichtung muss für die Messungen in einem konstanten Abstand über der zu messenden Fläche positioniert oder bewegt werden. Dabei entstehen zwischen der erfindungsgemäßen Vorrichtung und den elektrisch leitenden Flächen des Substrats kapazitive Kopplungen. Die kapazitive Kopplung zwischen der Sensorelektrode und dem Messobjekt definiert die Messkapazität. Diese Messkapazität fällt zwischen den Höhen versetzten Sensorelektroden unterschiedlich aus. Die Sensorelektrodenflächen der Sensorelektroden sind vertikal höhenversetzt. Bei ansonsten gleichen Bedingungen ist dieser Unterschied der Messkapazitäten vom Höhenversatz der Sensorelektrodenflächen und dem Abstand zwischen Sensor und den elektrisch leitenden Strukturen abhängig. Nachdem der Höhenversatz der Sensorelektrodenflächen bekannt ist, kann aus dem Messsignal der Abstand der elektrisch leitenden Strukturen zum Sensor berechnet werden und es kann bestimmt werden ob eine elektrisch leitende Struktur vorliegt oder nicht.

Gemäß der vorliegenden Anmeldung sind die Sensorelektroden zueinander höhenversetzt angeordnet, sodass der kapazitive Sensor dreidimensional ausgestaltet ist. Auf diese Weise kann der Abstand aus den Messsignalen berechnet werden. Gemäß der vorliegenden Erfindung kann eine einfache absolute Abstandsmessung direkt zur elektrisch leitenden Struktur und daraus abgeleitet, die Messung eines Höhenprofils verwirklicht werden. Dies erfordert keine direkte Ankontaktierung des Substrats zur Signalerzeugung. Es kann ebenso von der Substrataufnahme, die beispielsweise ein Chuck sein kann, ein Signal kapazitiv eingebunden werden. Es können ebenso elektrisch leitende Strukturen in nicht leitenden Substraten beziehungsweise durch die elektrischen Schichten hindurch gemessen und inspiziert werden. Ein erfindungsgemäßes Verfahren misst unabhängig von der Strukturgröße, solange die Sensorelektrodenflächen die leitfähige Struktur ganz oder in gleichen Anteilen überlappen. Da die Abstandsmessung lediglich von dem Verhältnis der beiden Messströme abhängig ist, kann ein beliebiges elektrisches Signal auf den Strukturen angelegt sein. Liegt kein Signal an, gibt es keinen Umladestrom. In diesem Fall kann der Sensor gegebenenfalls auf einem oszillierenden Potenzial gehalten werden. Die vorliegende Erfindung erfordert keine Kenntnis der Höhe der Anregungsspannung. Abhängig von einem Arbeitsabstand kann der Höhenversatz den Messbedingungen angepasst und optimiert werden.

Weitere vorteilhafte Ausgestaltungen werden in Verbindung mit den Unteransprüchen beansprucht.

Gemäß einer vorteilhaften Ausgestaltung können zwei Sensorelektrodenflächen ausgebildet sein und die Auswerteeinrichtung einen Teiler a/b aufweisen und mittels eines Verhältnisses der zwei Sensormesssignale zueinander einen Abstand h des Sensors zu einer elektrisch leitenden Struktur bestimmen.

Gemäß einer weiteren vorteilhaften Ausgestaltung kann die Auswerteeinrichtung bestimmen, ob sich zwischen einer der Sensorelektrodenflächen und dem Substrathalter eine elektrisch leitende Struktur erstreckt oder nicht.

Gemäß einer weiteren vorteilhaften Ausgestaltung kann die Auswerteeinrichtung bei Bestimmung eines Abstandes h größer einem Schwellwert bestimmen, dass sich zwischen der zugeordneten Sensorelektrode und dem Substrathalter keine elektrisch leitende Struktur erstreckt. Der Schwellwert kann beispielsweise ein maximal möglicher Abstand zwischen dem Sensor und dem Substrathalter sein.

Gemäß einer weiteren vorteilhaften Ausgestaltung kann in einer Ebene einer der Sensorelektrodenflächen mindestens eine elektrisch leitende Schirmungsschicht am Sensor ausgebildet sein. An der elektrisch leitenden Schirmungsschicht kann ein Massepotential angelegt sein.

Gemäß einer weiteren vorteilhaften Ausgestaltung kann die mindestens eine elektrisch leitende Schirmungsschicht die in der gleichen Ebene liegende Sensorelektrodenfläche ersetzen.

Gemäß einer weiteren vorteilhaften Ausgestaltung kann das Anregungssignal ein alternierendes Spannungs- und/oder Stromsignal sein.

Gemäß einer weiteren vorteilhaften Ausgestaltung kann ein Sensormesssignal jeweils ein Umladestrom sein.

Gemäß einer weiteren vorteilhaften Ausgestaltung können die Sensorelektrodenflächen zu den elektrisch leitenden Strukturen parallel positionierbar sein und sich parallel zu einer x-, y- Ebene eines orthogonalen Koordinatensystems erstrecken.

Gemäß einer weiteren vorteilhaften Ausgestaltung können die Sensorelektrodenflächen gleich groß sein.

Gemäß einer weiteren vorteilhaften Ausgestaltung können die Sensorelektrodenflächen zueinander kongruent sein.

Gemäß einer weiteren vorteilhaften Ausgestaltung können die Sensorelektrodenflächen zusammen eine Oberfläche des Substrats abdecken.

Gemäß einer weiteren vorteilhaften Ausgestaltung können mittels der Sensorelektrodenflächen als Substrat ein Bildschirmglassubstrat einer Flüssigkristallanzeige (LCD, Liquid Crystal Display) und als elektrisch leitende Strukturen Leiterbahnen oder Pixelflächen erfassbar sein. Ebenso können Substrat und elektrisch leitende Strukturen eine gedruckte Elektronik ausbilden. Die elektrisch leitenden Strukturen können Leiterbahnen oder Pixelflächen an TFT- Elektroden (Thin Film Transistor-Elektroden) sein.

Gemäß einer weiteren vorteilhaften Ausgestaltung kann eine Relativbewegungseinrichtung die Oberfläche des Substrats und den Sensor mit einem konstanten Abstand zueinander in eine Vielzahl von Messpositionen relativbewegen.

Gemäß einer weiteren vorteilhaften Ausgestaltung kann der Sensor eine Vielzahl von Gruppen von Sensorelektrodenflächen mit einem regelmäßigen Muster derart aufweisen, dass eine Oberfläche des Substrats abdeckbar, und eine Vielzahl von Messpositionen gleichzeitig bereitstellbar ist.

Gemäß einer weiteren vorteilhaften Ausgestaltung kann mittels des regelmäßigen Musters eine Oberfläche des Substrats zeilenförmig abdeckbar sein.

Die Erfindung wird anhand von Ausführungsbeispielen in Verbindung mit den Figuren näher beschrieben. Es zeigen:

Figur 1a und b Ausführungsbeispiele von zu inspizierenden elektrisch leitenden Strukturen;

Figuren 2a bis c Ausführungsbeispiele einer herkömmlichen berührungslosen kapazitiven Inspektion;

Figur 3 ein Ausführungsbeispiel einer erfindungsgemäßen Vorrichtung;

Figuren 4a bis c Ausführungsbeispiele erfindungsgemäßer Messungen;

Figur 5 ein Ausführungsbeispiel einer erfindungsgemäßen Abstandsberechnung;

Figur 6 Ausführungsbeispiele vorteilhafter Sensorelektroden;

Figuren 7a und b zwei Messbeispiele eines erfindungsgemäßen Verfahrens.

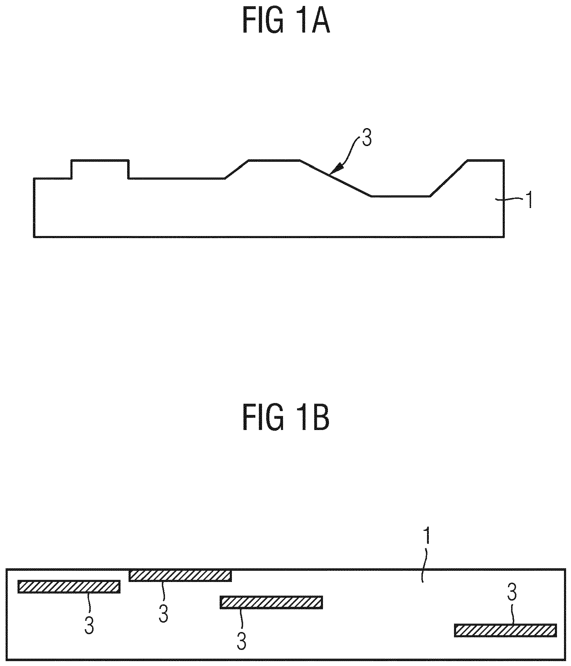

Figur 1a und 1b zeigen Ausführungsbeispiele von zu inspizierenden elektrisch leitenden Strukturen. Figur 1a zeigt eine elektrisch leitende Oberfläche als ein Ausführungsbeispiel einer elektrisch leitenden Struktur. Bezugszeichen 3 bezeichnet hier die elektrisch leitende Oberfläche. Figur 1b zeigt weitere Ausführungsbeispiele elektrisch leitender Strukturen 3. So können elektrisch leitende Strukturen 3 in einem Substrat 1 ausgebildet sein. Alternativ können elektrisch leitende Strukturen ebenso auf oder unter dem Substrat 1 ausgebildet sein. Die elektrisch leitenden Strukturen 3 können ebenso floatend bereitgestellt sein. Die Erfindung ermöglicht das kontaktfreie Inspizieren von insbesondere kleinen, floatenden elektrisch leitenden Strukturflächen 3 und darüber hinaus eine Messung eines Abstands von einem kapazitiven Sensor zur strukturierten Oberfläche des Substrats 1 gemäß Figur 1a. Über eine derartige Abstandsmessung kann eine Höhe als dritte Dimension einer dreidimensional elektrisch leitenden strukturierten Oberfläche 3 gemäß Figur 1a gemessen werden. Auf diese Weise kann eine Profilmessung erfolgen. Ebenso können elektrisch leitende Strukturen 3 im Inneren eines Dielektrikums gemäß Figur 1b geometrisch vermessen werden, und zwar ebenso in der dritten Dimension.

Figuren 2a bis c zeigen Ausführungsbeispiele einer herkömmlichen berührungslosen kapazitiven Inspektion. Es wird zwischen einer Oberfläche eines Substrats 1 und einem Sensor eine vom Ort abhängige Kapazität ausgebildet.

An diese kapazitive Kopplung können anschließend Spannungs- und Kapazitätsänderungen detektiert werden. Des Weiteren ist eine Kapazität zwischen einer Massefläche 8 und einer Substrataufnahme 5 ausgebildet. Figur 2a zeigt eine Anordnung ohne elektrisch leitende Struktur, Figur 2b mit elektrisch leitender Struktur 3 und Figur 2c zeigt die herkömmliche Anordnung mit einer elektrisch leitenden Struktur 3, deren Fläche der Fläche einer Substrataufnahme 5 entspricht.

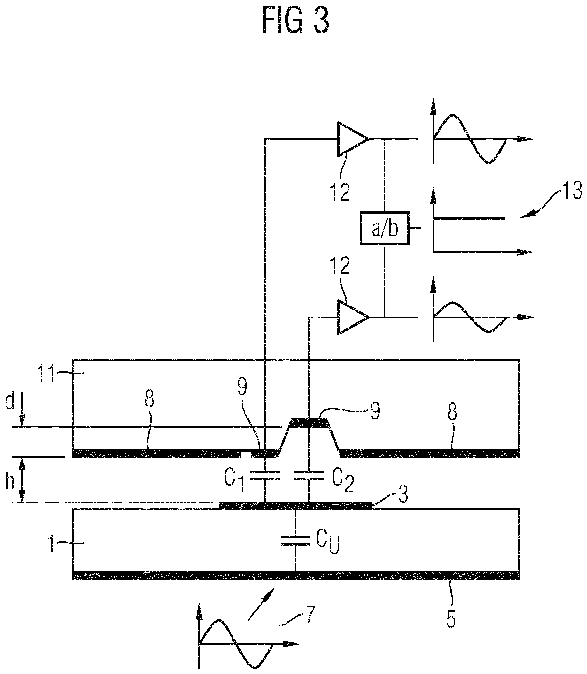

Figur 3 zeigt ein Ausführungsbeispiel einer erfindungsgemäßen Vorrichtung.

Gemäß der vorliegenden Erfindung wird ein kapazitiver Sensor verwendet, der mindestens zwei zueinander parallele, nicht in einer Ebene und relativ zu den zu inspizierenden Strukturen nebeneinander liegende separate Sensorelektrodenflächen bereitstellt. An dem Sensor ist auf dessen den zu inspizierenden Strukturen zugewandten Seite zur Erzeugung einer jeden erfindungsgemäßen Sensorelektrodenfläche besonders vorteilhaft jeweils eine separate Sensorelektrode ausgebildet. Eine derartige Sensorelektrode erstreckt sich dabei besonders vorteilhaft entlang einer x-, y- Ebene eines kartesischen Koordinatensystems, wobei eine räumliche Erstreckung der Sensorelektrode in einer z-Richtung kleiner ist. Dieser Unterschied kann im Bereich von beispielsweise mindestens einer Zehnerpotenz liegen. Beispielsweise kann eine auf diese Weise erzeugte Sensorelektrode als Sensorelektrodenschicht geschaffen sein. Eine Breite und Tiefe kann im Millimeterbereich und eine Dicke im Mikrometerbereich sein. Ein Verlauf einer den zu inspizierenden Strukturen zugewandten Oberfläche des kapazitiven Sensors ist derart ausgebildet, dass die einzelnen parallelen Sensorelektrodenschichten in der z-Richtung zueinander versetzt sind und zu einer x-, y- Ebene nebeneinander liegen. Eine jeweilige Sensorelektrode oder Sensorelektrodenschicht ist derart vom Sensor getragen, dass Feldlinien eines elektrischen Feldes lediglich an der dem Substrat zugewandten entlang der x-, y- Ebene sich räumlich erstreckenden Fläche der Sensorelektrode oder Sensorelektrodenschicht enden oder beginnen. Eine derartige Fläche wird als jeweilige Sensorelektrodenfläche bezeichnet. Eine Sensorelektrode ist damit besonders vorteilhaft als eine Sensorelektrodenschicht ausgebildet.

Ein Sensor 11 wird für Messungen in einem konstanten Abstand über eine Oberfläche eines Substrats 1 positioniert oder bewegt. Dabei kann der Sensor 11 beispielsweise mittels eines Luftlagers auf einem Luftkissen aufliegen. Auf diese Weise ergibt sich ein konstanter mittlerer Abstand, wobei Änderungen des Abstands durch das Luftlager ausgeglichen, das heißt gemittelt werden. Die zu messende elektrisch leitende Struktur 3 kann, falls diese existiert, auf oder in dem Substrat 1 ausgebildet sein. Es entstehen zwischen dem Sensor 11 und der elektrisch leitenden Struktur 3, die sich bevorzugt entlang einer Fläche parallel zu Flächen 9 von Sensorelektroden des Substrats 1 erstreckt, kapazitive Kopplungen C1 und C2. Die kapazitive Kopplung zwischen der Sensorelektrode 11 und dem Messobjekt 1 beziehungsweise 3 definiert die Messkapazität. Diese Messkapazität C1 und C2 ist zwischen einer ersten und einer zweiten Sensorelektrodenfläche 9 verschieden. Optional können auf der dem Messobjekt 1 und 3 zugewandten Seite des Sensors 11 Masseflächen 8 ausgebildet sein. Die Messkapazitäten C1 und C2 sind zwischen den höhenversetzten Sensorelektrodenflächen 9 verschieden. Bei ansonsten gleichen Bedingungen ist dieser Unterschied vom Höhenversatz der Sensorelektrodenflächen 9 und dem Abstand zwischen Sensor 11 und den elektrisch leitenden Strukturen 3 abhängig. Nachdem der Höhenversatz d der Sensorelektrodenflächen 9 bekannt ist, kann aus den Sensormesssignalen der Abstand h der elektrisch leitenden Strukturen 3 zum Sensor 11 berechnet werden. Figur 3 zeigt eine das Substrat 1 tragende und fixierende elektrisch leitende Substrataufnahme als einen Substrathalter 5, an den ein mittels einer Anregungssignalerzeugungseinrichtung 7 erzeugtes Anregungssignal angelegt ist beziehungsweise zu dem ein Anregungssignal zugeführt wird. Auf der der Substrataufnahme abgewandten Seite des Substrats 1 ist der, mindestens zwei mit zueinander unterschiedlichen, konstanten Abständen zu der Substrataufnahme 5 angeordneten Sensorelektrodenflächen 9 aufweisende, kapazitive Sensor 11 positioniert. Eine Messeinrichtung 12 erfasst ein jeweiliges Sensormesssignal der jeweiligen Sensorelektrodefläche 9, wobei mittels einer Auswerteeinrichtung 13 eine räumliche Erstreckung der elektrisch leitenden Struktur 3 mittels zweier Signale von dem Anregungssignal und den erfassten Sensormesssignalen bestimmt wird.

Mit dem kapazitiven Sensor 11 können lediglich Umladungsströme direkt gemessen werden. Diese werden durch folgende Gleichung beschrieben:

$$(1) \quad i = U\,\frac{dC}{dt} + C\,\frac{dU}{dt}$$

Die erste Hälfte dieser Gleichung (1) beschreibt den Umladestrom in Abhängigkeit der zeitlichen Kapazitätsänderung beim Schweben des Sensors 11 über ein Substrat 1. Die zweite Hälfte beschreibt den Umladestrom in Abhängigkeit von der Spannungsänderung über die Zeit. Nachdem eine Kapazitätsänderung typischerweise viel langsamer erfolgt als die angelegte Signalspannungsänderung, kann die erste Hälfte der Gleichung (1) bei den Messungen vernachlässigt werden und die Formel verändert sich zu Gleichung

$$(2) \quad i = C \frac{dU}{dt}$$

Nachdem die Sensorelektroden 9 eine gemeinsame Gegenelektrode haben, sind die beiden Umladeströme auch von derselben Spannung beziehungsweise Spannungsänderung abhängig. Damit verbleibt als einziger unterschiedlicher Einflussfaktor zwischen den einzelnen Messströmen die verschiedenen Messkapazitäten C1 und C2. Nachdem die Umladeströme direkt proportional zu den Messkapazitäten sind, sind ebenso die Verhältnisse der beiden Umladeströme zueinander und der beiden Messkapazitäten zueinander identisch. Das heißt, die Messkapazitäten können zwar nicht direkt bestimmt werden, es können jedoch die Verhältnisse der Umladeströme und damit der Messkapazitäten direkt aus den Umladeströmen berechnet werden. In erster Näherung können die Messkapazitäten zwischen den Sensorelektroden und den leitenden Strukturen als Plattenkondensatoren beschrieben werden. Die Kapazität eines Plattenkondensators wird durch folgende Formel (3) beschrieben:

$$(3) \quad C = \varepsilon \frac{A}{h}$$

Im Falle der versetzten Sensorelektroden lautet die Formel näherungsweise:

$$(4) \quad C = \varepsilon \frac{A}{h + d}$$

Das Verhältnis der Messkapazitäten berechnet sich für zwei Sensorelektroden 9 näherungsweise mit der Formel:

$$(5) \quad V_C = \frac{C1}{C2} = \frac{\varepsilon \frac{A_1}{h}}{\varepsilon \frac{A_2}{h + d}} = \frac{A_1}{A_2} \frac{h + d}{h}$$

Nachdem es sich lediglich um Näherungswerte handelt, müssen diese mittels eines Korrekturfaktors korrigiert werden. Ein derartiger Korrekturfaktor kann entweder durch Simulationen oder empirisch bestimmt werden. Ein Korrekturfaktor ist Abstandsabhängig und ist damit abhängig vom Verhältnis der Messkapazitäten. Der formelmäßige Ansatz mit Korrekturterm kann folgendermaßen angegeben werden:

$$(6) \quad V_C = \frac{C_1}{C_2} = \frac{i_1}{i_2} = \frac{A_1}{A_2} \frac{h + d}{h} \left(1 + k(V_c)\right)$$

Durch Auflösen nach dem Abstand h der elektrisch leitenden Strukturen 3 zum Sensor 11 erhält man die Formel:

$$(7) \quad h = \frac{d}{\frac{V_c}{(1 + k(V_c))} \frac{A_1}{A_2} - 1}$$

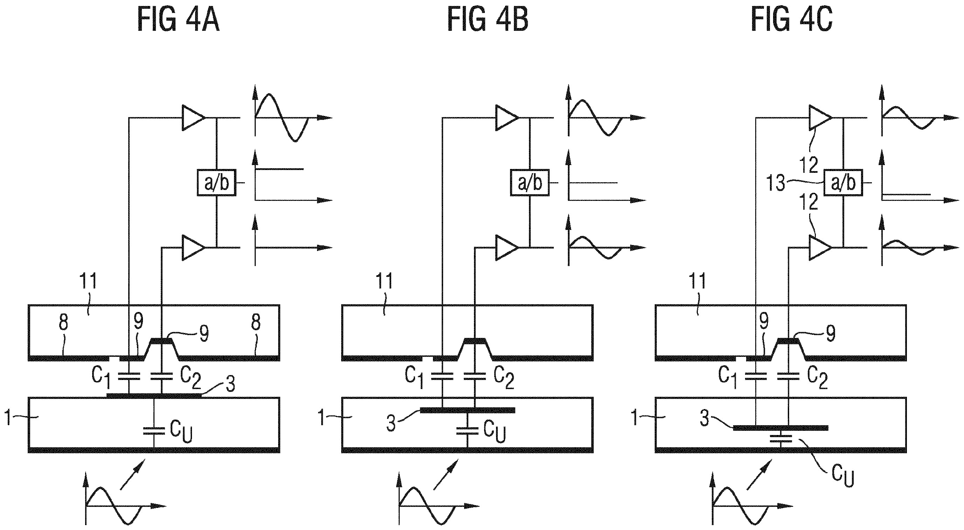

Figuren 4a bis c zeigen Ausführungsbeispiele erfindungsgemäßer Messungen. Es werden verschiedene elektrisch leitende Strukturen 3 dargestellt. Figur 4a zeigt eine elektrisch leitende Struktur auf einem Substrat 1, Figur 4b eine elektrisch leitende Struktur 3 in einem Substrat 1 und Figur 4c mit einer elektrisch leitenden Struktur 3 mit einem größeren Abstand h zum Sensor 11, wobei die elektrisch leitende Struktur 3 ebenso in einem Substrat 1 ausgebildet ist und damit zeigen Figuren 4a bis 4c anschaulich, wie sich das Verhältnis der beiden Messsignale mit dem Abstand h zur elektrisch leitenden Fläche 3 ändert. Die Messsignale werden mittels einer Messeinrichtung 12 für jedes Sensormesssignal an einer jeweiligen Sensorelektrode 9 gemessen. Eine Auswerteeinrichtung 13 kann beispielsweise das Verhältnis der beiden Sensormesssignale ermitteln. Auf diese Weise kann ebenso eine Aussage über das Vorhandensein oder Nichtvorhandensein einer elektrisch leitenden Fläche getroffen werden. Gemäß diesem Ausführungsbeispiel sind zwei verschiedene Dielektrika innerhalb des Abstands der Sensorelektroden 9 vorhanden, und zwar Luft und das Substrat 1. Die Verwendung von verschiedenen Dielektrika bewirkt einen effektiv größeren Abstand d. Dies sollte bei der Berechnung des Abstands h mit berücksichtigt werden. Um die sich ergebende Formel einfach zu halten, wurde bei der Herleitung in Verbindung mit Figur 3 vereinfachend mit einem Dielektrikum gerechnet. Das erfindungsgemäße Verfahren kann grundsätzlich aber ebenso mit verschiedenen Dielektrika ausgeführt werden.

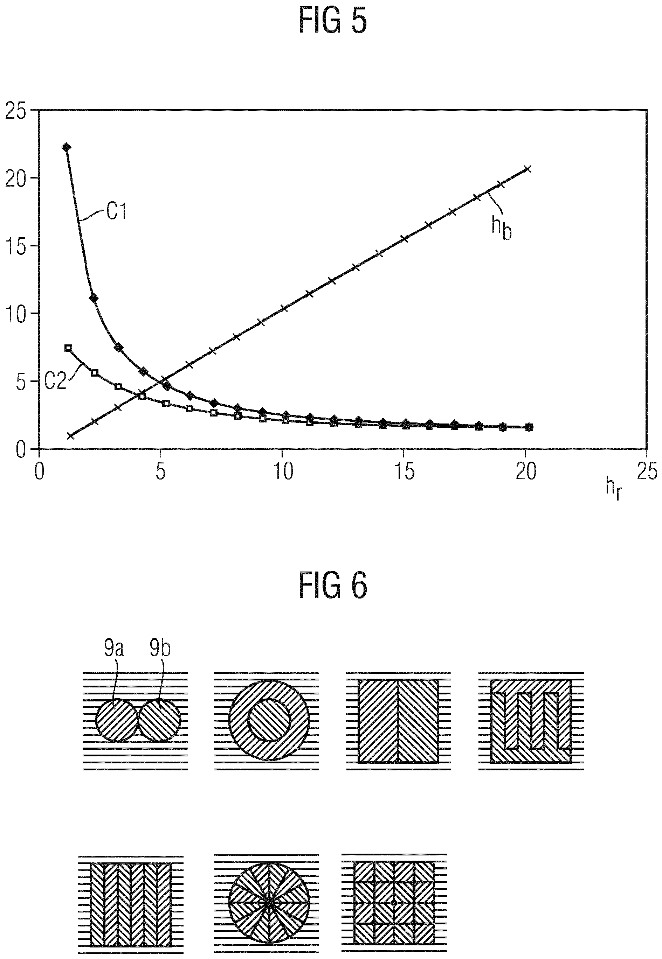

Figur 5 zeigt ein Ausführungsbeispiel einer erfindungsgemäßen Abstandsberechnung mittels simulierten Plattenkondensatorkapazitäten. Figur 5 zeigt eine Simulation. Dargestellt sind die beiden Plattenkapazitäten C1 und C2 zum Substrat 1 und die berechnete Entfernung $h_b$ über der tatsächlichen Entfernung $h_r$. Die Kapazitätswerte C1 und C2 wurden mit der Plattenkondensatorformel berechnet, sodass diese Werte nicht mit den realen Werten identisch sind. Bei dieser Simulation wurde als Sensorhöhenversatz d = 2 $\mu$m und als Sensorflächen 2500 $\mu m^2$ gerechnet.

Figur 6 zeigt Ausführungsbeispiele vorteilhafter Sensorelektrodenflächen 9. Damit die Sensorelektrodenflächen 9 gleichen Messbedingungen unterliegen und die Messung nicht verfälscht wird, müssen die einzelnen Sensorelektrodenflächen 9 mit effektiv gleich großen Substratflächenanteilen ein und derselben elektrisch leitenden Struktur 3 überlappen. Idealerweise sind die Geometrien von zwei Messelektrodenflächen 9 an die geometrische Struktur des Substrates 1 angepasst. Figur 6 zeigt vorteilhafte Geometrien bei einer erfindungsgemäßen Ausgestaltung mit zwei Sensorelektrodenflächen 9. Figur 6 zeigt Ausführungsbeispiele möglicher Ausgestaltungen von Sensorelektrodenflächen 9. Die schräg schraffierten Flächen stellen zwei zueinander höhenversetzte Sensorelektrodenflächen 9a und 9b dar.

Vorstehende Berechnungen und Figuren behandeln jeweils lediglich zwei Sensorelektrodenflächen 9. Vom Schutzumfang dieser Anmeldung sind aber ebenso Ausführungsformen mit mehr als zwei Sensorelektrodenflächen umfasst.

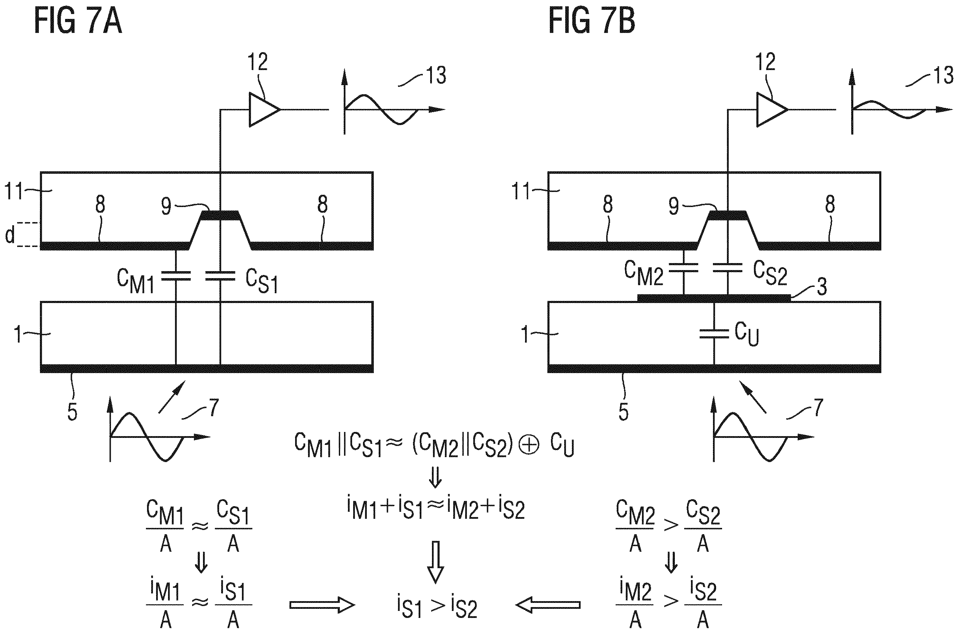

Figuren 7a und b zeigen zwei Messbeispiele, welche nicht Teil der Erfindung sind, zur kontaktlosen und zerstörungsfreien Inspektion einer Vielzahl von elektrisch leitenden Strukturen 3. Mit einem ersten Schritt S1 erfolgt ein Bereitstellen einer das Substrat 1 kontaktierenden und positionierenden elektrisch leitenden Substrataufnahme, an die ein mittels einer Anregungssignalerzeugungseinrichtung 7 erzeugtes Anregungssignal angelegt wird. Mit einem zweiten Schritt S2 wird ein auf der der Substrataufnahme abgewandten Seite des Substrats 1 an ein zwei mit zueinander unterschiedlichen, konstanten Abständen zu der Substrataufnahme angeordneten Sensorelektrodenflächen 9 aufweisender kapazitiver Sensor 11 angeordnet. Gemäß diesem Ausführungsbeispiel ist die Sensorelektrodenfläche 9 die dem Substrat 1 am nächsten ist gleichzeitig als eine Massefläche 8 ausgebildet. Mit einem dritten Schritt S3 werden mittels einer Messeinrichtung 12 jeweilige Sensormesssignale, die vorteilhaft Umladeströme sind, an einer jeweiligen Sensorelektrodenfläche 9 gemessen. Mit einem vierten Schritt S4 erfolgt ein Auswerten der beiden Sensormesssignale mittels einer Auswerteeinrichtung 13. Mit einem derartigen Verfahren können beispielsweise folgende Messungen durchgeführt werden:

a) Topographiemessung:

Durch ein Verfahren des Sensors 11 in einer X- und einer Y-Richtung kann eine Abtastung über das gesamte Substrat 1 erfolgen. Auf diese Weise kann unter anderem eine Topographie eines zu messenden Objekts beziehungsweise von Strukturen 1 und 3 gemessen werden.

b) Prüfen, ob eine Leiterbahn vorhanden oder nicht vorhanden ist, oder Messen der lateralen Geometrie einer leitenden Fläche:

Eine derartige Messung von insbesondere kleinen Strukturen kann ebenso mit einem Sensor 11 mit lediglich einer Sensorelektrodenfläche 9 erfolgen. Diese Sensorelektrodenfläche 9 muss dann gegenüber einer Massefläche 8 versetzt sein. Die Funktion der zweiten Sensorelektrodenfläche 9 übernimmt in diesem Fall dann die Massefläche 8. Figur 7a zeigt einen ersten Fall, bei dem keine elektrisch leitende Struktur unter dem Sensor 11 angeordnet ist. Ist unter dem Sensor 11 keine elektrisch leitende Struktur angeordnet, koppeln sowohl die Massefläche 8, als auch die Sensorelektrodenfläche 9 mit ungefähr der gleichen Kapazität pro Flächeneinheit auf die Substrataufnahme, die beispielsweise als Chuck ausgeführt sein kann. Die Kapazitäten pro Flächeneinheit sind ungefähr gleich groß, da der vergleichsweise geringe Höhenversatz d zwischen Elektrodenfläche 9 und Massenfläche 8 vernachlässigbar ist gegenüber dem Abstand zur Substrataufnahme. Entsprechend ist ebenso der Strom pro Flächeneinheit in etwa gleich groß. Figur 7b zeigt den zweiten Fall, bei dem eine elektrisch leitende Struktur 3 unter dem Sensor 11 angeordnet ist. Sobald eine elektrisch leitende Struktur 3 unter der Sensorelektrode 11 positioniert ist, bildet diese eine Äquipotentialfläche aus. Die Gesamtkapazität zwischen der Substrataufnahme und dem Sensor 11 ändert sich dabei nicht nennenswert, weil entsprechende leitende Flächen, die beispielsweise lediglich aufgedampft sind, in der Regel sehr dünn sind und damit den effektiven Abstand zwischen Sensor 11 und der Substrataufnahme beziehungsweise Substrathalter 5 lediglich minimal verkürzen. Allerdings ändern sich die Kapazitätsverhältnisse zwischen der leitenden Struktur 3, die eine Äquipotentialfläche ausbildet, und der Sensorelektrodenfläche 9 beziehungsweise der Massefläche 8. Dies ist dadurch verursacht, dass der Versatz d der Sensorelektrodenfläche 9 gegenüber dem Abstand h des Sensors 11 zur elektrisch leitenden Struktur 3 nicht mehr vernachlässigt werden kann. Das Verhältnis der Ströme pro Flächeneinheit entspricht dem Verhältnis der Kapazitäten pro Flächeneinheit, während sich der Gesamtstrom fast nicht ändert. Somit fließt bei einer gemäß Figuren 7a und 7b oberen Sensorelektrodenfläche 9 weniger Strom, wenn sich eine elektrisch leitende Struktur 3 unter dieser Sensorelektrodenfläche 9 befindet. Damit lassen sich über die Stromstärke die Strukturen 3 sowie deren laterale Abmessungen inspizieren.

Die hier beschriebenen Ausführungsbeispiele der vorliegenden Erfindung zeigen einen Versatz d nach oben. Alternativ kann dieser Versatz d ebenso nach unten ausgebildet sein. In einem derartigen Fall ändert sich das Verhältnis der Kapazitäten und Ströme entsprechend. Die in Figur 7 dargestellten beiden Fälle sind in Figur 7 zusätzlich mathematisch beschrieben.

## Patentansprüche

1.  Vorrichtung zur kapazitiven, kontaktlosen und zerstörungsfreien Inspektion einer Vielzahl von auf oder in einem Substrat (1) erzeugten elektrisch leitenden Strukturen (3), die Vorrichtung aufweisend:

    - eine Anregungssignalerzeugungseinrichtung (7) zum Anlegen eines Anregungssignals;
    - einen mindestens zwei mit zu einander unterschiedlichen, konstanten Abständen parallel zu einer Oberfläche des Substrats (1) und relativ zu der Oberfläche des Substrats (1) nebeneinander angeordnete Sensorelektrodenflächen (9) aufweisenden kapazitiven Sensor (11);
    - eine Messeinrichtung (12) zur Erfassung von Sensormesssignalen;
    - eine Auswerteeinrichtung (13) zur Bestimmung einer räumlichen Erstreckung einer elektrisch leitenden Struktur (3) mittels der erfassten Sensormesssignale;

    wobei:

    - ein das Substrat positionierender elektrisch leitender Substrathalter (5) vorgesehen ist, an den ein mittels der Anregungssignalerzeugungseinrichtung (7) erzeugtes Anregungssignal anlegbar ist,
    - der kapazitive Sensor (11) dazu eingerichtet ist, auf einer dem Substrathalter (5) abgewandten Seite des Substrats (1) positioniert zu werden,
    - die Messeinrichtung (12) dazu eingerichtet ist, ein jeweiliges Sensormesssignal an einer jeweiligen Sensorelektrodenfläche (9) zu erfassen.

2.  Vorrichtung nach Anspruch 1,
    **dadurch gekennzeichnet, dass**
    zwei Sensorelektrodenflächen (9a, 9b) ausgebildet sind und die Auswerteeinrichtung (13) einen Teiler (a/b) aufweist und mittels eines Verhältnisses der zwei Sensormesssignale zueinander einen Abstand (h) des Sensors (11) zu einer elektrisch leitenden Struktur (3) bestimmt.

3.  Vorrichtung nach Anspruch 1 oder 2,
    **dadurch gekennzeichnet, dass**
    die Auswerteeinrichtung (13) bestimmt, ob sich zwischen einer der Sensorelektrodenflächen (9a) und dem Substrathalter (5) eine elektrisch leitende Struktur (3) erstreckt oder nicht.

4.  Vorrichtung nach Anspruch 3,
    **dadurch gekennzeichnet, dass**
    die Auswerteeinrichtung (13) bei Bestimmung eines Abstandes (h) größer einem Schwellwert bestimmt, dass sich zwischen der zugeordneten Sensorelektrode (9a) und dem Substrathalter (5) keine elektrisch leitende Struktur (3) erstreckt.

5.  Vorrichtung nach Anspruch 1,
    **dadurch gekennzeichnet, dass**
    in einer Ebene einer der Sensorelektrodenflächen (9b) mindestens eine elektrisch leitende Schirmungsschicht (8) am Sensor (11) ausgebildet ist.

6.  Vorrichtung nach Anspruch 1,
    **dadurch gekennzeichnet, dass**

das Anregungssignal ein alternierendes Spannungs- und/oder Stromsignal ist.

7. Vorrichtung nach Anspruch 1,
**dadurch gekennzeichnet, dass**
ein Sensormesssignal jeweils ein Umladestrom ist.

8. Vorrichtung nach Anspruch 1,
**dadurch gekennzeichnet, dass**
die Sensorelektrodenflächen (9a, 9b) zu den elektrisch leitenden Strukturen (3) parallel positionierbar sind und sich parallel zu einer x-, y- Ebene eines orthogonalen Koordinatensystems erstrecken.

9. Vorrichtung nach Anspruch 1 oder 8,
**dadurch gekennzeichnet, dass**
die Sensorelektrodenflächen (9a, 9b) gleich groß sind.

10. Vorrichtung nach Anspruch 8 oder 9,
**dadurch gekennzeichnet, dass**
die Sensorelektrodenflächen (9a, 9b) zueinander kongruent sind.

11. Vorrichtung nach Anspruch 9 oder 10,
**dadurch gekennzeichnet, dass**
die Sensorelektrodenflächen (9) zusammen eine Oberfläche des Substrats (1) abdecken.

12. Vorrichtung nach Anspruch 1,
**dadurch gekennzeichnet, dass**
mittels der Sensorelektrodenflächen (9)als Substrat (1) ein Bildschirmglassubstrat einer Flüssigkristallanzeige (LCD, Liquid Crystal Display) und als elektrisch leitende Strukturen (3) Leiterbahnen oder Pixelflächen erfassbar sind.

13. Vorrichtung nach Anspruch 1,
**dadurch gekennzeichnet, dass**
eine Relativbewegungseinrichtung die Oberfläche des Substrats (1) und den Sensor (11) mit einem konstanten Abstand zueinander in eine Vielzahl von Messpositionen relativbewegt.

14. Vorrichtung nach Anspruch 1 oder 13,
**dadurch gekennzeichnet, dass**
der Sensor (11) eine Vielzahl von Gruppen von Sensorelektrodenflächen (9a, 9b) mit einem regelmäßigen Muster derart aufweist, dass eine Oberfläche des Substrats (1) abdeckbar und eine Vielzahl von Messpositionen gleichzeitig bereitstellbar ist.

15. Vorrichtung nach Anspruch 14,
**dadurch gekennzeichnet, dass**
mittels des regelmäßigen Musters eine Oberfläche des Substrats (1) zeilenförmig abdeckbar ist.

16. Verfahren zur kapazitiven, kontaktlosen und zerstörungsfreien Inspektion einer Vielzahl von auf oder in einem Substrat (1) erzeugten elektrisch leitenden Strukturen (3), mit den Schritten

   - Positionieren des Substrats (1) mittels eines elektrisch leitenden Substrathalters (5), an den ein mittels einer Anregungssignalerzeugungseinrichtung (7) erzeugtes Anregungssignal angelegt wird;
   - Positionieren eines mindestens zwei mit zueinander unterschiedlichen, konstanten Abständen zu einer Oberfläche des Substrats (1) und relativ zu der Oberfläche des Substrats (1) nebeneinander angeordneten Sensorelektrodenflächen (9) aufweisenden kapazitiven Sensor (11) auf der dem Substrathalter (5) abgewandten Seite des Substrats (1);
   - Erfassen eines jeweiligen Sensormesssignals an einer jeweiligen Sensorelektrodenfläche (9) mittels einer Messeinrichtung (12);
   - mittels einer Auswerteeinrichtung (13) ausgeführtes Bestimmen einer räumlichen Erstreckung einer elektrisch leitenden Struktur (3) mittels der erfassten Sensormesssignale.

17. Verfahren nach Anspruch 16,

**dadurch gekennzeichnet, dass**
zwei Sensorelektrodenflächen (9a, 9b) ausgebildet werden und die Auswerteeinrichtung (13) einen Teiler (a/b) aufweist und mittels eines Verhältnisses der zwei Sensormesssignale zueinander einen Abstand (h) des Sensors (11) zu einer elektrisch leitenden Struktur (3) bestimmt.

18. Verfahren nach Anspruch 16 oder 17,
**dadurch gekennzeichnet, dass**
die Auswerteeinrichtung (13) bestimmt, ob sich zwischen einer der Sensorelektrodenflächen (9a) und dem Substrathalter (5) eine elektrisch leitende Struktur (3) erstreckt oder nicht.

19. Verfahren nach Anspruch 18,
**dadurch gekennzeichnet, dass**
die Auswerteeinrichtung (13) bei Bestimmung eines Abstandes (h) größer als einen Schwellwert bestimmt, dass sich zwischen der zugeordneten Sensorelektrode (9a) und dem Substrathalter (5) keine elektrisch leitende Struktur (3) erstreckt.

20. Verfahren nach Anspruch 16,
**dadurch gekennzeichnet, dass**
in einer Ebene einer der Sensorelektrodenflächen (9b) mindestens eine elektrisch leitende Schirmungsschicht (8) am Sensor (11) ausgebildet wird, wobei an der elektrisch leitenden Schirmungsschicht (8) ein Massepotential angelegt wird.

21. Verfahren nach Anspruch 16,
**dadurch gekennzeichnet, dass**
als das Anregungssignal ein alternierendes Spannungs- und/oder Stromsignal eingeprägt wird.

22. Verfahren nach Anspruch 16,
**dadurch gekennzeichnet, dass**
ein Sensormesssignal jeweils ein Umladestrom ist.

23. Verfahren nach Anspruch 16,
**dadurch gekennzeichnet, dass**
die Sensorelektrodenflächen (9a, 9b) zu den elektrisch leitenden Strukturen (3) parallel positionierbar sind und sich parallel zu einer x-, y- Ebene eines orthogonalen Koordinatensystems erstrecken.

24. Verfahren nach Anspruch 16 oder 23,
**dadurch gekennzeichnet, dass**
die Sensorelektrodenflächen (9a, 9b) gleich groß sind.

25. Verfahren nach Anspruch 24,
**dadurch gekennzeichnet, dass**
die Sensorelektrodenflächen (9a, 9b) zueinander kongruent sind.

26. Verfahren nach Anspruch 24 oder 25,
**dadurch gekennzeichnet, dass**
die Sensorelektrodenflächen (9) zusammen die Oberfläche des Substrats (1)abdecken.

27. Verfahren nach Anspruch 16,
**dadurch gekennzeichnet, dass**
mittels der Sensorelektrodenflächen (9) als Substrat (1) ein Bildschirmglassubstrat einer Flüssigkristallanzeige (LCD, Liquid Crystal Display) und als elektrisch leitende Strukturen (3) Leiterbahnen oder Pixelflächen erfassbar sind.

28. Verfahren nach Anspruch 16,
**dadurch gekennzeichnet, dass**
eine Relativbewegungseinrichtung die Oberfläche des Substrats (1) und den Sensor (11) mit einem konstanten Abstand zueinander in eine Vielzahl von Messpositionen relativbewegt.

29. Verfahren nach Anspruch 16 oder 28,

**dadurch gekennzeichnet, dass**
der Sensor (11) eine Vielzahl von Gruppen von Sensorelektrodenflächen (9a, 9b) mit einem regelmäßigen Muster derart aufweist, dass eine Oberfläche des Substrats (1) abdeckbar und eine Vielzahl von Messpositionen gleichzeitig bereitstellbar ist.

30. Verfahren nach Anspruch 29,
**dadurch gekennzeichnet, dass**
mittels des regelmäßigen Musters eine Oberfläche des Substrats (1) zeilenförmig abdeckbar ist.

**Claims**

1. Apparatus for the capacitive, contactless and nondestructive inspection of a multiplicity of electrically conductive structures (3) produced on or in a substrate (1), the apparatus having:

   - an excitation signal generating device (7) for applying an excitation signal;
   - a capacitive sensor (11), which has at least two sensor electrode areas (9) arranged at mutually different, constant distances parallel to a surface of the substrate (1) and alongside one another relative to the surface of the substrate (1) ;
   - a measuring device (12) for detecting sensor measurement signals;
   - an evaluation device (13) for determining a spatial extent of an electrically conductive structure (3) by means of the detected sensor measurement signals;

   wherein:

   - an electrically conductive substrate holder (5) is provided, which positions the substrate and to which an excitation signal generated by means of the excitation signal generating device (7) can be applied;
   - the capacitive sensor (11) is configured to be positioned on a side of the substrate (1) which faces away from the substrate holder (5),
   - the measuring device (12) is configured to detect a respective sensor measurement signal at a respective sensor electrode area (9).

2. Apparatus according to Claim 1,
   **characterized in that**
   two sensor electrode areas (9a, 9b) are formed and the evaluation device (13) has a divider (a/b) and determines a distance (h) between the sensor (11) and an electrically conductive structure (3) by means of a ratio of the two sensor measurement signals to one another.

3. Apparatus according to Claim 1 or 2,
   **characterized in that**
   the evaluation device (13) determines whether or not an electrically conductive structure (3) extends between one of the sensor electrode areas (9a) and the substrate holder (5).

4. Apparatus according to Claim 3,
   **characterized in that** the evaluation device (13), upon determining a distance (h) greater than a threshold value, determines that no electrically conductive structure (3) extends between the assigned sensor electrode (9a) and the substrate holder (5).

5. Apparatus according to Claim 1,
   **characterized in that**
   in a plane of one of the sensor electrode areas (9b), at least one electrically conductive shielding layer (8) is formed on the sensor (11).

6. Apparatus according to Claim 1,
   **characterized in that**
   the excitation signal is an alternating voltage and/or current signal.

7. Apparatus according to Claim 1,

**characterized in that**
a sensor measurement signal is in each case a charge-reversal current.

**8.** Apparatus according to Claim 1,
**characterized in that**
the sensor electrode areas (9a, 9b) can be positioned parallel to the electrically conductive structures (3) and extend parallel to an x-, y-plane of an orthogonal coordinate system.

**9.** Apparatus according to Claim 1 or 8,
**characterized in that**
the sensor electrode areas (9a, 9b) are identical in size.

**10.** Apparatus according to Claim 8 or 9,
**characterized in that** the sensor electrode areas (9a, 9b) are congruent to one another.

**11.** Apparatus according to Claim 9 or 10,
**characterized in that**
the sensor electrode areas (9) together cover a surface of the substrate (1).

**12.** Apparatus according to Claim 1,
**characterized in that**
the sensor electrode areas (9) can detect, as substrate (1), a screen glass substrate of a liquid crystal display (LCD) and, as electrically conductive structures (3), conductor tracks or pixel areas.

**13.** Apparatus according to Claim 1,
**characterized in that**
a relative movement device relatively moves the surface of the substrate (1) and the sensor (11) at a constant distance with respect to one another into a multiplicity of measurement positions.

**14.** Apparatus according to Claim 1 or 13,
**characterized in that**
the sensor (11) has a multiplicity of groups of sensor electrode areas (9a, 9b) with a regular pattern such that it is possible to cover a surface of the substrate (1) and simultaneously provide a multiplicity of measurement positions.

**15.** Apparatus according to Claim 14,
**characterized in that**
by means of the regular pattern, a surface of the substrate (1) can be covered in linear fashion.

**16.** Method for the capacitive, contactless and nondestructive inspection of a multiplicity of electrically conductive structures (3) produced on or in a substrate (1), comprising the following steps:

- positioning the substrate (1) by means of an electrically conductive substrate holder (5), to which an excitation signal generated by means of an excitation signal generating device (7) is applied;
- positioning a capacitive sensor (11) on that side of the substrate (1) which faces away from the substrate holder (5), said capacitive sensor having at least two sensor electrode areas (9) arranged at mutually different, constant distances with respect to a surface of the substrate (1) and alongside one another relative to the surface of the substrate (1);
- detecting a respective sensor measurement signal at a respective sensor electrode area (9) by means of a measuring device (12);
- determining, performed by means of an evaluation device (13), a spatial extent of an electrically conductive structure (3) by means of the detected sensor measurement signals.

**17.** Method according to Claim 16,
**characterized in that**
two sensor electrode areas (9a, 9b) are formed and the evaluation device (13) has a divider (a/b) and determines a distance (h) between the sensor (11) and an electrically conductive structure (3) by means of a ratio of the two sensor measurement signals to one another.

**18.** Method according to Claim 16 or 17,
**characterized in that**
the evaluation device (13) determines whether or not an electrically conductive structure (3) extends between one of the sensor electrode areas (9a) and the substrate holder (5).

**19.** Method according to Claim 18,
**characterized in that**
the evaluation device (13), upon determining a distance (h) greater than a threshold value, determines that no electrically conductive structure (3) extends between the assigned sensor electrode (9a) and the substrate holder (5).

**20.** Method according to Claim 16,
**characterized in that**
in a plane of one of the sensor electrode areas (9b), at least one electrically conductive shielding layer (8) is formed on the sensor (11), wherein a ground potential is applied to the electrically conductive shielding layer (8).

**21.** Method according to Claim 16,
**characterized in that**
an alternating voltage and/or current signal is impressed as the excitation signal.

**22.** Method according to Claim 16,
**characterized in that**
a sensor measurement signal is in each case a charge-reversal current.

**23.** Method according to Claim 16,
**characterized in that**
the sensor electrode areas (9a, 9b) can be positioned parallel to the electrically conductive structures (3) and extend parallel to an x-, y-plane of an orthogonal coordinate system.

**24.** Method according to Claim 16 or 23,
**characterized in that**
the sensor electrode areas (9a, 9b) are identical in size.

**25.** Method according to Claim 24,
**characterized in that**
the sensor electrode areas (9a, 9b) are congruent to one another.

**26.** Method according to Claim 24 or 25,
**characterized in that**
the sensor electrode areas (9) together cover the surface of the substrate (1).

**27.** Method according to Claim 16,
**characterized in that**
the sensor electrode areas (9) can detect, as substrate (1), a screen glass substrate of a liquid crystal display (LCD) and, as electrically conductive structures (3), conductor tracks or pixel areas.

**28.** Method according to Claim 16,
**characterized in that**
a relative movement device relatively moves the surface of the substrate (1) and the sensor (11) at a constant distance with respect to one another into a multiplicity of measurement positions.

**29.** Method according to Claim 16 or 28,
**characterized in that**
the sensor (11) has a multiplicity of groups of sensor electrode areas (9a, 9b) with a regular pattern such that it is possible to cover a surface of the substrate (1) and simultaneously provide a multiplicity of measurement positions.

**30.** Method according to Claim 29,
**characterized in that**
by means of the regular pattern, a surface of the substrate (1) can be covered in linear fashion.

**Revendications**

1. Système d'inspection capacitive, sans contact et sans destruction d'une pluralité de structures (3) conductrices de l'électricité produites sur ou dans un substrat (1), le système comportant :

   - un dispositif (7) de production d'un signal d'excitation pour appliquer un signal d'excitation ;
   - un capteur (11) capacitif ayant au moins deux surfaces (9) d'électrode disposées à des distances constantes différentes les unes des autres parallèlement à une surface du substrat (1) et les unes à côté des autres par rapport à la surface du substrat (1) ;
   - un dispositif (12) de mesure pour détecter des signaux du capteur ;
   - un dispositif (13) d'exploitation pour déterminer une étendue dans l'espace d'une structure (3) conductrice de l'électricité au moyen des signaux de mesure du capteur qui ont été détectés ;

   dans lequel :

   - il est prévu, mettant le substrat en position, un porte-substrat (5) conducteur de l'électricité, auquel un signal d'excitation produit au moyen du dispositif (7) de production d'un signal d'excitation peut être appliqué,
   - le capteur (11) capacitif est conçu pour être mis en position sur une face du substrat (1) loin du porte-substrat (5),
   - le dispositif (12) de mesure est conçu pour détecter un signal respectif du capteur sur une surface (9) respective d'électrode du capteur.

2. Système suivant la revendication 1,
   **caractérisé en ce que**
   il est constitué deux surfaces (9a, 9b) d'électrode du capteur et le dispositif (13) d'exploitation a un diviseur (a/b) et, au moyen d'un rapport entre les deux signaux de mesure du capteur l'un par rapport à l'autre, on détermine une distance (h) du capteur (11) à une structure (3) conductrice de l'électricité.

3. Système suivant la revendication 1 ou 2,
   **caractérisé en ce que**
   le dispositif (13) d'exploitation détermine si une structure (3) conductrice de l'électricité s'étend ou non entre l'une des surfaces (9a) d'électrode du capteur et le porte-substrat (5).

4. Système suivant la revendication 3,
   **caractérisé en ce que**
   le dispositif (13) d'exploitation détermine, lorsqu'il détermine une distance (h) plus grande qu'une valeur de seuil, qu'une structure (3) conductrice de l'électricité ne s'étend pas entre l'électrode (9a) de capteur associée et le porte-substrat (5).

5. Système suivant la revendication 1,
   **caractérisé en ce que**
   dans un plan de l'une des surfaces (9b) d'électrode du capteur est constituée, au moins sur le capteur (11), une couche (8) de blindage conductrice de l'électricité.

6. Système suivant la revendication 1,
   **caractérisé en ce que**
   le signal d'excitation est un signal alternatif de tension et/ou de courant.

7. Système suivant la revendication 1,
   **caractérisé en ce que**
   un signal de mesure du capteur est respectivement un courant de recharge.

8. Système suivant la revendication 1,
   **caractérisé en ce que**
   les surfaces (9a, 9b) d'électrode de capteur peuvent être mises en position parallèlement aux structures (3) conductrices de l'électricité et s'étendent parallèlement à un plan x, un plan y d'un système de coordonnées orthogonales.

9. Système suivant la revendication 1 ou 8,
   **caractérisé en ce que**

les surfaces (9a, 9b) d'électrode du capteur ont la même dimension.

10. Système suivant la revendication 8 ou 9,
**caractérisé en ce que**
les surfaces (9a, 9b) d'électrode du capteur sont congruentes entre elles.

11. Système suivant la revendication 9 ou 10,
**caractérisé en ce que**
les surfaces (9) d'électrode du capteur recouvrent ensemble une surface du substrat (1).

12. Système suivant la revendication 1,
**caractérisé en ce que**
au moyen des surfaces (9) d'électrode du capteur, on peut détecter comme substrat (1) un substrat de verre d'écran d'un affichage (LCD, Liquid Crystal Display) à cristal liquide et, comme structures (3) conductrices de l'électricité, des pistes conductrices ou des surfaces de pixels.

13. Système suivant la revendication 1,
**caractérisé en ce que**
un dispositif de déplacement relatif déplace relativement la surface du substrat (1) et le capteur (11) à une distance constante l'un de l'autre en une pluralité de positions de mesure.

14. Système suivant la revendication 1 ou 13,
**caractérisé en ce que**
**en ce que** le capteur (11) a une pluralité de groupes de surfaces (9a, 9b) d'électrode de capteur suivant un motif régulier, de manière à pouvoir recouvrir une surface du substrat (1) et à pouvoir disposer en même temps d'une pluralité de positions de mesure.

15. Système suivant la revendication 14,
**caractérisé en ce que**
une surface du substrat (1) peut être couverte en forme de ligne au moyen du motif régulier.

16. Procédé d'inspection capacitif, sans contact et sans destruction, d'une pluralité de structures (3) conductrices de l'électricité produites sur ou dans un substrat (1), comprenant les stades

- on met le substrat (1) en position au moyen d'un porte-substrat (5) conducteur de l'électricité, auquel on applique un signal d'excitation produit au moyen d'un dispositif (7) de production d'un signal d'excitation ;
- on met en position un capteur (11) capacitif ayant au moins deux surfaces (9) d'électrode disposées à des distances constantes différentes les unes des autres d'une surface du substrat (1) et les unes à côté des autres par rapport à la surface du substrat (1) du côté du substrat (1) loin du porte-substrat (5) ;
- on détecte un signal respectif de mesure du capteur sur une surface (9) respective d'électrode du capteur au moyen d'un dispositif (12) de mesure ;
- on détermine, au moyen d'un dispositif (13) d'exploitation, une étendue dans l'espace d'une structure (3) conductrice de l'électricité au moyen des signaux de mesure du capteur qui ont été détectés.

17. Procédé suivant la revendication 16,
**caractérisé en ce que**
on constitue deux surfaces (9a, 9b) d'électrode de capteur et le dispositif (13) d'exploitation a un diviseur (a/b) et, au moyen d'un rapport des deux signaux de mesure du capteur entre eux, détermine une distance (h) du capteur (11) à une structure (3) conductrice de l'électricité.

18. Procédé suivant la revendication 16 ou 17,
**caractérisé en ce que**
le dispositif (13) d'exploitation détermine si une structure (3) conductrice d'électricité s'étend ou non entre l'une des surfaces (9a) d'électrode du capteur et le porte-substrat (5).

19. Procédé suivant la revendication 18,
**caractérisé en ce que**
le dispositif (13) d'exploitation détermine, lorsqu'il détermine une distance (h) plus grande qu'une valeur de seuil, qu'une structure (3) conductrice de l'électricité ne s'étend pas entre l'électrode (9a) de capteur associée et le porte-substrat (5).

**20.** Procédé suivant la revendication 16,
**caractérisé en ce que**
dans un plan de l'une des surfaces (9b) d'électrode du capteur, on constitue, sur le capteur (11), au moins une couche (8) de blindage conductrice de l'électricité, dans lequel on applique un potentiel de masse à la couche (8) de blindage conductrice de l'électricité.

**21.** Procédé suivant la revendication 16,
**caractérisé en ce que**
on applique, comme signal d'excitation, un signal alternatif de tension et/ou de courant.

**22.** Procédé suivant la revendication 16,
**caractérisé en ce que**
un signal de mesure du capteur est respectivement un courant de recharge.

**23.** Procédé suivant la revendication 16,
**caractérisé en ce que**
les surfaces (9a, 9b) d'électrode de capteur peuvent être mises en position parallèlement aux structures (3) conductrices de l'électricité et s'étendent parallèlement à un plan x, un plan y d'un système de coordonnées orthogonales.

**24.** Procédé suivant la revendication 16 ou 23,
**caractérisé en ce que**
les surfaces (9a, 9b) d'électrode du capteur ont la même dimension.

**25.** Procédé suivant la revendication 24,
**caractérisé en ce que**
les surfaces (9a, 9b) d'électrode du capteur sont congruentes entre elles.

**26.** Procédé suivant la revendication 24 ou 25,
**caractérisé en ce que**
les surfaces (9) d'électrode du capteur recouvrent ensemble la surface du substrat (1).

**27.** Procédé suivant la revendication 16,
**caractérisé en ce que**
au moyen des surfaces (9) d'électrode du capteur, on peut détecter comme substrat (1) un substrat de verre d'écran d'un affichage (LCD, Liquid Crystal Display) à cristal liquide et, comme structures (3) conductrices de l'électricité, des pistes conductrices ou des surfaces de pixels.

**28.** Procédé suivant la revendication 16,
**caractérisé en ce que**
un dispositif de déplacement relatif déplace relativement la surface du substrat (1) et le capteur (11) à une distance constante l'un de l'autre en une pluralité de positions de mesure.

**29.** Procédé suivant la revendication 16 ou 28,
**caractérisé en ce que**
**en ce que** le capteur (11) a une pluralité de groupes de surfaces (9a, 9b) d'électrode de capteur suivant un motif régulier, de manière à pouvoir recouvrir une surface du substrat (1) et à pouvoir disposer en même temps d'une pluralité de positions de mesure.

**30.** Procédé suivant la revendication 29,
**caractérisé en ce que**
une surface du substrat (1) peut être couverte en forme de ligne au moyen du motif régulier.

# FIG 1A

# FIG 1B

# FIG 3

FIG 4A  FIG 4B  FIG 4C

# FIG 5

# FIG 6

# FIG 7A

# FIG 7B

EP 2 707 734 B1

$$C_{M1} \| C_{S1} \approx (C_{M2} \| C_{S2}) \oplus C_U$$

$$\Downarrow$$

$$i_{M1} + i_{S1} \approx i_{M2} + i_{S2}$$

$$\Downarrow$$

$$\frac{C_{M1}}{A} \approx \frac{C_{S1}}{A} \qquad\qquad i_{S1} > i_{S2} \qquad\qquad \frac{C_{M2}}{A} > \frac{C_{S2}}{A}$$

$$\Downarrow \qquad\qquad\qquad\qquad\qquad \Downarrow$$

$$\frac{i_{M1}}{A} \approx \frac{i_{S1}}{A} \implies \qquad \Longleftarrow \frac{i_{M2}}{A} > \frac{i_{S2}}{A}$$

**EP 2 707 734 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008030545 A1
- DE 102009022965 A1
- US 20020163342 A1